# EUROPÄISCHE PATENTSCHRIFT

(11) **EP 1 005 090 B1**
(45) Veröffentlichungstag und Bekanntmachung des Hinweises auf die Patenterteilung: **05.09.2001**
(21) Anmeldenummer: 99121970.0
(22) Anmeldetag: 10.11.1999
(51) Int. Cl.: H01L 27/115, H01L 21/8247, H01L 21/02

(54) **Halbleiterbauelement mit zumindest einem Widerstandselement aufweisenden Kondensator sowie Verfahren zu dessen Herstellung**
Semiconductor component with at least a capacitor having a resistance element and its fabrication process
Dispositif à semi-conducteur avec un condensateur comportant une résistance, et méthode pour sa fabrication

(30) Priorität: 25.11.1998 DE 19854418
(43) Veröffentlichungstag der Anmeldung: 31.05.2000
(73) Patentinhaber: Infineon Technologies AG, 81669 München (DE)
(72) Erfinder: Schindler, Günther Dr., 80802 München (DE); Hartner, Walter, 81829 München (DE)
(74) Vertreter: Zedlitz, Peter, Dipl.-Inf.

(56) Entgegenhaltungen:
- DE-A- 19 636 054
- US-A- 5 579 258
- US-A- 5 625 529

## Beschreibung

Die Erfindung liegt auf dem Gebiet der Halbleitertechnik und betrifft ein Halbleiterbauelement mit zumindest einem Kondensator, bei dem sich zwischen einer ersten und einer zweiten Elektrode eine Metalloxidschicht befindet, wobei in der Metalloxidschicht durch einen vorgewählten Spannungsunterschied zwischen der ersten und zweiten Elektrode eine remanente elektrische Polarisation herbeiführbar ist.

Für zukünftige Generationen von Halbleiterspeichern werden unter anderem sogenannte nichtflüchtige Speicher vorgeschlagen. Bei diesen umfassen die einzelnen Speicherzellen jeweils einen Kondensator, der als Kondensatordielektrikum eine ferroelektrische Schicht aufweist. In dieser Schicht kann durch Anlegen eines elektrischen Feldes eine remanente Polarisation des ferroelektrischen Materials herbeigeführt werden. In Abhängigkeit von der Richtung der Polarisation läßt sich somit eine Information in dem Kondensator abspeichern. Da anders als in den sogenannten DRAMs die Information nicht durch angesammelte Ladungen gespeichert wird, besteht auch nicht die Gefahr einer Selbstentladung des Kondensators und damit des Verschwindens der Information. Die im Ferroelektrikum erzeugte Polarisation bleibt prinzipiell beliebig lange erhalten, weswegen auch von nichtflüchtigen Speichern gesprochen wird.

Ein Halbleiterbauelement der eingangs genannten Art, welches nichtflüchtige Speicherelemente enthält, ist beispielsweise in der US 5,615,144 beschrieben. Die dortigen Speicherzellen umfassen je einen ferroelektrischen Kondensator, dessen eine seiner beiden Elektroden über einen Auswahltransistor mit einer Bitleitung verbunden ist. Die andere Elektrode ist mit einer sogenannten Plateleitung verbunden, an der ein Pulssignal anliegt. Bei geöffnetem Auswahltransistor wird eine Elektrode des Kondensators auf das Potential der nun mit ihr verbundenen Bitleitung gebracht. In Abhängigkeit von den Signalen auf der Bit- und der Plateleitung wird das auf das Kondensatordielektrikum wirkende elektrische Feld verändert und somit die Ausrichtung und Höhe der remanenten Polarisation beeinflußt.

Bei geschlossenem Auswahltransistor ist eine Elektrode des Kondensators von der Bitleitung getrennt. Es hat sich jedoch gezeigt, das sich diese Kondensatorelektrode gegenüber der anderen beispielsweise durch Leckströme aus Nachbarzellen oder des geschlossenen Auswahltransistors elektrostatisch auflädt, und damit zu einem ungewollten Löschen der Polarisation oder zu einem Umpolarisieren des Kondensatordielektriums beitragen kann. Dies führt jedoch zu einem irreversiblen Datenverlust, der grundsätzlich vermieden werden muß.

Eine nichtflüchtige Speicherzelle ist auch aus DE 196 36 054 bekannt.

Es ist daher Aufgabe der Erfindung, ein Halbleiterbauelement zu schaffen, bei dem eine ungewollte Veränderung der eingespeicherten Information vermieden wird, sowie ein Verfahren zur Herstellung eines derartigen Halbleiterbauelements anzugeben.

Der erste Teil dieser Aufgabe wird erfindungsgemäß bei einem Halbleiterbauelement der eingangs genannten Art dadurch gelöst, daß am Kondensator zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist.

Grundgedanke der Erfindung ist, ein definiertes Kurzschlußelement parallel zum Kondensator zu schalten, damit angesammelte Ladungen über dieses abfließen können und somit ein Potentialausgleich zwischen den beiden Kondensatorelektroden herbeigeführt wird. Der vorbestimmte Widerstandswert des Widerstandselements bzw. des Kurzschlußelements sollte dabei so bemessen sein, daß einerseits das gewollte Herbeiführen der Polarisation bei Adressierung des Kondensators nur unwesentlich behindert wird, und andererseits ein ausreichender Potentialausgleich bei Nichtadressierung erfolgen kann. Die Höhe des Widerstandswertes des Widerstandselements muß daher durch eine Gesamtbetrachtung der realisierten elektrischen Schaltung ermittelt werden. Ein wesentlicher Aspekt dabei ist, daß beim Einschreiben der remanenten Polarisation die dazu notwendige Spannung nahezu vollständig über dem Kondensator und dem dazu parallel geschalteten Widerstandselement abfällt. D. h., daß der aus beiden gebildete Gesamtwiderstand immer noch deutlich höher als die Summe aller Leitungswiderstände und des Transistorwiderstands (bei geöffnetem Transistor) ist. Das Widerstandselement muß also so bemessen sein, daß der Spannungsimpuls zum Herbeiführen der remanenten Polarisation über seine gesamte Zeitdauer gesehen zu einem effektiv auf das Kondensatordielektrikum wirkende elektrische Feld führt, das ausreichend ist, eine remanente (bleibende) elektrische Polarisation im Kondensatordielektrikum herbeizuführen.

Andererseits sollte der Widerstandswert des Widerstandselements ausreichend gering sein, um den Potentialausgleich der beiden Elektroden des Kondensators bei einem unbeabsichtigten Aufladen der ersten und der zweiten Elektrode gegeneinander zu ermöglichen. Da eine elektrostatische Aufladung der Elektroden im Gegensatz zur Zeitdauer des vorgewählten Spannungsunterschieds zum Herbeiführen der remanenten elektrischen Polarisation im wesentlichen deutlich langsamer erfolgt, kann die Größe des Widerstandswertes des Widerstandselements hinsichtlich der geforderten Bedingungen relativ leicht errechnet werden. So sollte dieser Wert geringer als der Widerstandswert der Metalloxidschicht sein und ein Entladen des Kondensators mit einer Zeitkonstante ermöglichen, die mindestens zehnmal größer als die Zeitdauer zum Herbeiführen der remanenten Polarisation ist. Eine günstige Größe des Widerstandswerts des Widerstandselements liegt etwa zwischen 1 MΩ und 100 GΩ, wobei eine Größe zwischen 10 MΩ und 100 MΩ bevorzugt wird.

Bei mehreren Speicherzellen, beispielsweise bei ferroelektrischen RAM's, weist bevorzugt jede Speicherzelle ein eigenes Widerstandselement auf. Diese Zuordnung ist auch bei Speicherzellen sinnvoll, bei denen die zweiten Elektroden durch eine gemeinsame Metallschicht gebildet werden.

In einer bevorzugten Ausführungsform wird das Widerstandselement aus Polysilizium oder aus einem leitfähigen Nitrid oder Silizid, z.B. einem Metallsilizid, hergestellt. Der Widerstandswert des Widerstandselements, d. h. sein effektiv wirkender Gesamtwiderstand, kann dabei durch geeignete Dotierung bzw. geeignete geometrische Dimensionierung (effektiv wirkende Querschnittsfläche) eingestellt werden.

Bevorzugt wird das Widerstandselement als selbstjustierter seitlicher Randsteg an zumindest einer Seitenfläche der Metalloxidschicht ausgebildet. Bei einer weiteren bevorzugten Ausführungsform wird das Widerstandselement durch ein mit leitfähigem Material befülltes Kontaktloch in der Metalloxidschicht gebildet. Eine weitere Möglichkeit, ein Widerstandselement zu bilden, besteht darin, daß das Widerstandselement durch eine die gesamte Oberseite der ersten Elektrode bedeckende Schicht aus leitfähigem Material gebildet ist, und diese Schicht zumindest an einer Seitenfläche der ersten Elektrode die dort unter Zwischenlage der Metalloxidschicht aufgetragene zweite Elektrode überdeckt.

Bei den vorgenannten bevorzugten Ausführungsbeispielen wird das Widerstandselement durch Aufbringen und Strukturieren einer zusätzlichen Schicht hergestellt. Im Gegensatz dazu kann bei einer weiteren bevorzugten Ausführungsform das Widerstandselement auch durch zumindest einen in seinem Widerstandswert veränderten Bereich der Metalloxidschicht gebildet sein. Dabei ist darauf zu achten, daß die Metalloxidschicht nur lokal verändert wird, um eine Degeneration der gewünschten elektrischen Eigenschaften der Metalloxidschicht (Höhe der remanenten Polarisation) auszuschließen. Ein derartig veränderter Bereich der Metalloxidschicht läßt sich beispielsweise durch Eindiffusion zumindest eines Diffusionsstoffs herbeiführen. Dabei kann dieser Diffusionsstoff ein bereits in der Metalloxidschicht enthaltenes Metall sein. In diesem Fall werden die stöchiometrischen Verhältnisse in der Metalloxidschicht lokal verändert und dadurch die Leitfähigkeit der Metalloxidschicht in diesen Bereichen erhöht.

Die Wahl der Diffusionsstoffe richtet sich unter anderem nach der verwendeten Metalloxidschicht. Als Metalloxidschichten kommen bevorzugt ferroelektrische Metalloxide wie beispielsweise Strontium-Bismut-Tantalat (SrBi₂Ta₂O₉, SBT), niobiumdotiertes Strontium-Bismut-Tantalat (SrBi₂Ta₂₋ₓNbₓO₉, SBTN), Blei-Zirkon-Titanat (PbTiO₃, PZT) oder deren Abkömmlinge zur Anwendung. Sofern der Diffusionsstoff ein bereits in der Metalloxidschicht enthaltenes Metall sein soll, wird er damit aus der Gruppe Bismut, Strontium, Niob, Blei, Zirkon, Titan und Tantal ausgewählt. Wird dagegen ein Fremdstoff als Diffusionsstoff bevorzugt, so können beispielsweise Ruthenium, Eisen bzw. Tantal oder Titan verwendet werden.

Vorteilhaft ist weiterhin, daß die Widerstandselemente selbstjustiert direkt am Kondensator geschaffen werden, wodurch sich der Platzbedarf der Speicherzelle nur unwesentlich oder gar nicht erhöht. Die Integration des Widerstandselements zieht dabei nur einen minimalen zusätzlichen Prozeßaufwand nach sich, wobei technologisch gut beherrschte Prozesse zur Anwendung kommen.

Es ist weiterhin vorteilhaft, den in seinem Widerstandswert veränderten Bereich der Metalloxidschicht durch Ionenimplantation zu schaffen. Dazu werden Ionen im wesentlichen in einem lokal begrenzten Bereich der Metalloxidschicht implantiert und nachfolgend durch eine geeignete Temperaturbehandlung aktiviert. Dies gestattet in vorteilhafter Weise die relativ einfache Bildung des Widerstandselements in der Metalloxidschicht.

Der zweite Teil der oben genannten Aufgabe wird gelöst durch ein Verfahren zur Herstellung eines Halbleiterbauelements mit zumindest einem Kondensator, bei dem sich zwischen einer ersten und einer zweiten Elektrode eine Metalloxidschicht befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist, mit folgenden Verfahrensschritten:
- Aufbringen eines Elektrodenmaterials und einer metalloxidhaltigen Schicht auf eine Substratoberfläche;
- selektives Ätzen des Elektrodenmaterials und der metalloxidhaltigen Schicht unter Bildung der ersten Elektrode mit darüber angeordneter Metalloxidschicht;
- konformes Aufbringen eines leitfähigen Materials mit vorbestimmter Materialstärke;
- anisotropes Ätzen des leitfähigen Materials, so daß ein Widerstandselement in Form eines selbstjustierten seitlich Randstegs an zumindest einer Seitenflanke der Metalloxidschicht und der ersten Elektrode entsteht; und
- Aufbringen eines Elektrodenmaterials zur Bildung einer zweiten Elektrode.

Gemäß diesem Verfahren wird nach der Bildung der ersten Elektrode mit darüber angeordneter Metalloxidschicht zumindest ein Widerstandselement in Form eines selbstjustierten seitlichen Randstegs an einer Seitenflanke der Metalloxidschicht und der Elektrode gebildet. Das Elektrodenmaterial und die metalloxidhaltige Schicht, aus denen die erste Elektrode und die Metalloxidschicht gebildet werden, können dabei nacheinander oder in einem gemeinsamen Ätzschritt geätzt werden.

Die genannte Aufgabe wird weiterhin gelöst durch ein Verfahren zur Herstellung eines Halbleiterbauelements mit zumindest einem Kondensator, bei dem sich zwischen einer ersten und einer zweiten Elektrode eine Metalloxidschicht befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist, mit folgenden Verfahrensschritten:
- Aufbringen eines Elektrodenmaterials auf eine Substratoberfläche;
- bereichsweises Ätzen des Elektrodenmaterials unter Bildung der ersten Elektrode;
- konformes Aufbringen einer metalloxidhaltigen Schicht zur Bildung der Metalloxidschicht;
- Aufbringen eines Elektrodenmaterials zur Bildung der zweiten Elektrode;
- bereichsweises Durchätzen der zweiten Elektrode und der Metalloxidschicht unter Bildung eines bis zur ersten Elektrode reichenden Kontaktlcchs; und
- Füllen dieses Kontaktlochs mit einem leitfähigen Material zur Bildung eines Widerstandselements.

Hierdurch wird das Widerstandselement in Form eines Kontaktlochs zumindest in der Metalloxidschicht gebildet. Es ist dabei möglich, das Kontaktloch unmittelbar in der Metalloxidschicht zu bilden und mit einem geeigneten Material zu befüllen, oder das Kontaktloch erst nach der Bildung der zweiten Elektrode in einem gemeinsamen Ätzschritt in dieser und in der Metalloxidschicht zu schaffen.

Zur Lösung der gestellten Aufgabe trägt ebenfalls ein Verfahren zur Herstellung eines Halbleiterbauelements mit zu mindestens einem Kondensator bei, bei dem sich zwischen einer ersten und einer zweiten Elektrode eine Metalloxidschicht befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist, wobei das Verfahren folgende Verfahrensschritte aufweist:
- Aufbringen eines Elektrodenmaterials auf eine Substratoberfläche;
- selektives Ätzen des Elektrodenmaterials unter Bildung der ersten Elektrode;
- konformes Aufbringen einer metalloxidhaltigen Schicht zur Bildung der Metalloxidschicht;
- Aufbringen eines Elektrodenmaterials zur Bildung der zweiten Elektrode;
- zumindest bereichsweises Entfernen der Metalloxidschicht und der zweiten Elektrode von einer Oberseite der ersten Elektrode; und
- konformes Aufbringen eines leitfähigen Materials mit vorbestimmter Materialstärke, das durch den Kontakt mit der Oberseite der ersten Elektrode und der zweiten Elektrode das Widerstandselement bildet.

Dieses Verfahren dient somit dazu, das Widerstandselement in Form einer die Oberseite der ersten Elektrode zumindest bereichsweise überdeckenden Schicht auszubilden. Sofern die Metalloxidschicht und die zweite Elektrode vollständig von der Oberseite der ersten Elektrode entfernt werden, bedeckt das leitfähige Material (Widerstandselement) vollständig die Oberfläche und zumindest einige Seitenbereiche der ersten Elektrode, wobei an den Seitenbereichen der ersten Elektrode zwischen dem leitfähigen Material und der ersten Elektrode die Metalloxidschicht und die zweite Elektrode angeordnet sind.

Es ist jedoch auch möglich, das Widerstandselement in Form eines selbstjustierten seitlichen Randstegs auf der Oberseite der ersten Elektrode zu schaffen, wobei dieser Randsteg seitlich der bereichsweise von der Oberseite der ersten Elektrode entfernten Metalloxidschicht und der zweiten Elektrode gebildet wird.

Ein weiteres, die genannte Aufgabe lösendes Verfahren zur Herstellung eines Halbleiterbauelements mit zumindest einem Kondensator, bei dem sich zwischen einer ersten und einer zweiten Elektrode eine Metalloxidschicht befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist, weist folgende Verfahrensschritte auf:
- Aufbringen einer zumindest einen Diffusionsstoff enthaltenden Diffusionsschicht auf eine Substratoberfläche;
- Aufbringen eines Elektrodenmaterials auf diese Schicht;
- bereichsweises Ätzen des Elektrodenmaterials unter Bildung der ersten Elektrode und bereichsweises Ätzen der Diffusionsschicht;
- konformes Aufbringen einer metalloxidhaltigen Schicht zur Bildung der Metalloxidschicht;
- Aufbringen eines Elektrodenmaterials zur Bildung der zweiten Elektrode; und
- Durchführen einer Temperaturbehandlung, bei der der Diffusionsstoff aus der Diffusionsschicht zumindest teilweise in die Metalloxidschicht unter Bildung des Widerstandselements diffundiert.

Bei diesem Verfahren wird zunächst eine einen Diffusionsstoff enthaltende Diffusionsschicht aufgebracht, die zumindest bereichsweise mit der später zu bildenden Metalloxidschicht in Kontakt tritt. Durch die abschließende Temperaturbehandlung diffundieren der oder die Diffusionsstoffe aus der Diffusionsschicht in die Metalloxidschicht und bilden dort zumindest in der Nähe der Kontaktbereiche zwischen Diffusionsschicht und Metalloxidschicht zumindest einen Bereich mit einer gegenüber der übrigen und nicht dotierten Metalloxidschicht höheren Leitfähigkeit. Dieser Bereich stellt dann das Widerstandselement dar. Vorteilhaft hierbei ist, daß die Diffusion nur bereichsweise erfolgt und somit die angestrebten elektrischen Eigenschaften der übrigen Metalloxidschicht, insbesondere hinsichtlich der remanenten elektrischen Polarisation, nicht beeinflußt werden.

Sofern der Kontaktbereich zwischen der Diffusionsschicht und der Metalloxidschicht zur Unterstützung der Diffusion vergrößert werden soll, wird nach dem Ätzen des Elektrodenmaterials zur Bildung der ersten Elektrode eine konforme Opferschicht abgeschieden und diese nachfolgend anisotrop unter Bildung eines unmittelbar seitlich neben der ersten Elektrode angeordneten Randstegs geätzt. Bei dem sich daran anschließenden Ätzen der Diffusionsschicht dient dieser an den Seitenbereichen der ersten Elektrode verbliebene Randsteg zusammen mit der ersten Elektrode als Ätzmaske, so daß die geätzte Diffusionsschicht somit um die Breite der konformen Opferschicht (Breite des Randstegs) unter der ersten Elektrode hervorsteht. Der Randsteg wird anschließend vollständig entfernt. Beim darauffolgenden Abscheiden der metalloxidhaltigen Schicht werden somit auch die hervorstehenden Bereiche der Diffusionsschicht von der metalloxidhaltigen Schicht überdeckt und ein größeres Kontaktgebiet zwischen beiden gebildet. Die Dicke der Opferschicht richtet sich nach der gewünschten Größe dieses Kontaktbereichs und letztendlich nach der Größe des durch die Temperaturbehandlung entstandenen leitfähigen Bereichs in der Metalloxidschicht.

Die obengenannte Aufgabe wird weiterhin gelöst durch ein Verfahren zur Herstellung eines Halbleiterbauelements mit zumindest einem Kondensator, bei dem sich zwischen einer ersten und einer zweiten Elektrode eine Metalloxidschicht befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist, folgenden Verfahrensschritten :
- Aufbringen eines Elektrodenmaterials auf eine Substratoberfläche;
- Aufbringen einer metalloxidhaltigen Schicht auf das Elektrodenmaterial;
- Aufbringen eines weiteren Elektrodenmaterials auf die metalloxidhaltige Schicht;
- zumindest bereichsweises Entfernen der beiden Elektrodenmaterialien und der metalloxidhaltigen Schicht unter Bildung eines Schichtstapels bestehend aus der unteren Elektrode, der Metalloxidschicht und der zweiten Elektrode; und
- Implantieren von Ionen zumindest in die Metalloxidschicht.

Bevorzugt erfolgt bei diesem Verfahren die Herstellung des Widerstandselements durch seitliche Implantation in die Metalloxidschicht. Die Implantation kann einseitig oder allseitig in die Metalloxidschicht erfolgen, wobei bei letzterer Variante die Metalloxidschicht, d.h. der gesamte Schichtstapel, möglichst gleichmäßig um ein im wesentlichen senkrecht zum Schichtstapel angeordnete Drehachse bewegt wird. Die zur Implantation verwendeten Stoffe werden bevorzugt aus der oben angegebenen Gruppe der Diffusionsstoffe ausgewählt.

Im folgenden wird die Erfindung anhand eines Ausführungsbeispiels beschrieben und in Figuren dargestellt. Es zeigen:
- Figur 1: den Schaltplan einer Speicherzelle mit ferroelektrischem Kondensator,
- Figur 2: den Querschnitt einer Speicherzelle mit integriertem Widerstandselement,
- Figuren 3a bis 3d: Verfahrensschritte zur Herstellung eines Widerstandselements in Form von seitlichen Randstegen,
- Figuren 4a bis 4d: Verfahrensschritte zur Bildung des Widerstandselements in Form eines Kontaktlochs,
- Figuren 5a bis 5c: Verfahrensschritte zur Bildung des Widerstandselements auf der Oberseite der ersten Elektrode,
- Figuren 6a und 6b: Verfahrensschritte zur Bildung des Widerstandselements auf einer bereichsweise entblößten Oberseite der ersten Elektrode,
- Figuren 7a bis 7c: Verfahrensschritte zur Bildung des Widerstandselements in Form eines leitfähigen Bereiches der Metalloxidschicht,
- Figuren 8a bis 8d: Verfahrensschritte zur Bildung eines Widerstandselements in Form von leitfähigen Bereichen in der Metalloxidschicht unter Verwendung einer unter der ersten Elektrode hervorstehenden Diffusionsschicht, und
- Figuren 9a bis 9c: Verfahrensschritte zur Bildung eines Widerstandselements durch Ionenimplantation.

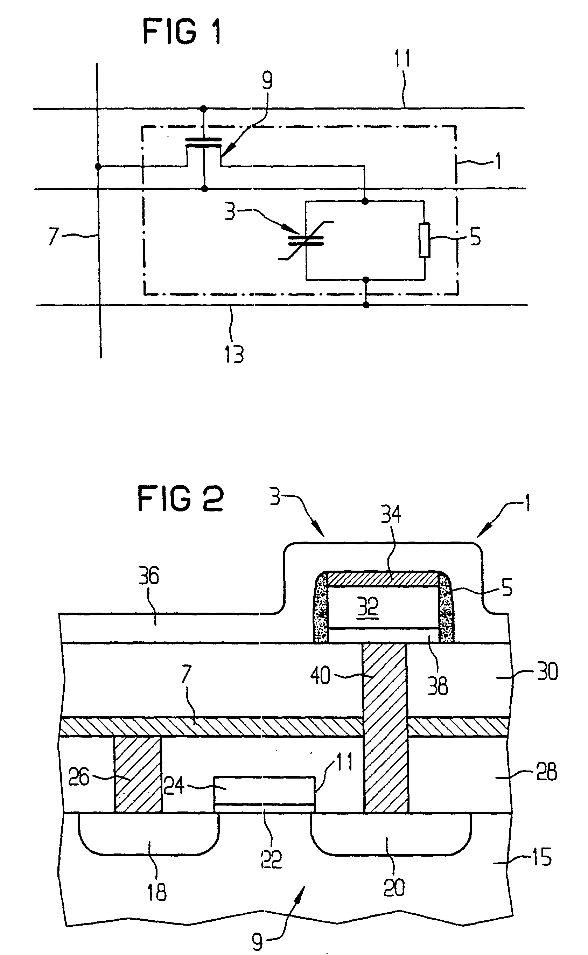

Figur 1 zeigt einen elektrischen Schaltplan einer Speicherzelle 1. Diese umfaßt einen ferroelektrischen Kondensator 3, einen zu diesem parallel geschalteten Widerstand 5 sowie einen den Kondensator 3 mit der Bitleitung 7 verbindenden Auswahltransistor 9. Der Auswahltransistor 9 wird über eine Wortleitung 11 angesteuert. Der Kondensator 3 und der Widerstand 5 sind weiterhin mit der sogenannten Plateleitung 13 verbunden. An dieser liegt ein Rechtecksignal an, das periodisch eine Elektrode des Kondensators auf einen hohen Spannungswert bringt. Bei geöffnetem Auswahltransistor 9 ist die andere Elektrode des Kondensators 3 mit der Bitleitung 7 verbunden. In Abhängigkeit von dem dort anliegenden Signal weist entweder die mit der Bitleitung 7 verbundene Elektrode des Kondensators 3 eine höhere oder niedrigere Spannung als die mit der Plateleitung 13 verbundene Elektrode auf, so daß auf das Kondensatordielektrikum ein in seiner Höhe und in seinem Vorzeichen vorbestimmtes elektrisches Feld wirkt. Dieses führt in Abhängigkeit von seiner Feldstärke zu einer remanenten Polarisation in dem Kondensatordielektrikum des Kondensators 3. Der parallel geschaltete Widerstand 5 vermindert den effektiv wirkenden Spannungsunterschied und damit das elektrische Feld nur unwesentlich, so daß die angelegte Spannung im wesentlichen vollständig über dem Kondensator 3 abfällt.

Soll der Speicherinhalt, d. h. die Richtung der eingeschriebenen Polarisation, ausgelesen werden, wird in den Kondensator 3 ein vorbestimmter Wert eingeschrieben und der dazu notwendige Strom gemessen. Wies der Kondensator bereits die einzuschreibende Polarisation auf, fließt nur ein geringer Strom. Muß jedoch der Kondensator umpolarisiert werden, wird ein entsprechend hoher Stromfluß registriert. Die Höhe des gemessenen Stromflusses gibt Auskunft über den Speicherinhalt. Da letzterer beim Auslesen verändert wird, muß dieser anschließend erneut eingeschrieben werden. Der parallel geschaltete Widerstand 5 darf beim Auslesen des Speicherinhalts nicht zu einer Fehlmessung führen, d. h. er muß so bemessen sein, daß der bei der angelegten Meßspannung durch den Widerstand 5 fließende Strom immer noch deutlich kleiner als der zur Umpolarisation des Kondensators 3 notwendige Stromfluß ist. Beispielsweise sollte der Widerstand um etwa wenigstens einem Zehntel kleiner als der Widerstand der Metalloxidschicht sein, jedoch einen Wert von etwa 1 MΩ nicht unterschreiten.

Ein bevorzugter Aufbau einer Speicherzelle 1 ist in Figur 2 gezeigt. In einem Siliziumsubstrat 15 sind ein Sourcegebiet 18 und ein Draingebiet 20 des Auswahltransistors 9 voneinander beabstandet integriert. Auf dem Siliziumsubstrat 15 befindet sich zwischen dem Sourcegebiet 18 und dem Draingebiet 20 ein Gatedielektrikum 22 und eine Gateelektrode 24. Letztere ist mit der Wortleitung 11 verbunden. Das Sourcegebiet 18 ist über ein mit einem leitfähigen Material befülltes Kontaktloch 26, daß sich in einer ersten planarisierenden Schicht 28 befindet, mit der Bitleitung 7 verbunden. Oberhalb der Bitleitung 7 und der ersten planarisierenden Schicht 28 befindet sich eine zweite planarisierende Schicht 30, die im folgenden das Substrat 30 darstellt. Auf dem Substrat 30 befindet sich der Kondensator 3 mit dem an den Seitenwänden des Kondensators angeordneten Widerstandselement 5. Der Kondensator 3 besteht dabei aus einer ersten (unteren) Elektrode 32, einer Metalloxidschicht 34 und einer zweiten (oberen) Elektrode 36. Zwischen der ersten Elektrode 32 und dem Substrat 30 befindet sich weiterhin eine Barrierenschicht 38, die eine Diffusion des Elektrodenmaterials in das sich unterhalb der Barrierenschicht 38 befindende und das Substrat 30 und die erste planarisierende Schicht 28 durchsetzende und mit einem leitfähigen Material befüllte Kontaktloch 40 verhindern soll. Das Kontaktloch 40 führt bis zum Draingebiet 20. Dadurch wird die erste Elektrode 32 des Kondensators 3 mit dem Auswahltransistor 9 verbunden. Die Barrierenschicht 38 besteht bevorzugt aus einer Titan/Titannitridschicht-Kombination. Als Elektrodenmaterial für die erste und zweite Elektrode 32 und 36 wird bevorzugt Platin verwendet, hingegen für die Metalloxidschicht 34 SBT. Das Widerstandselement 5 besteht im vorliegenden Ausführungsbeispiel bevorzugt aus Polysilizium.

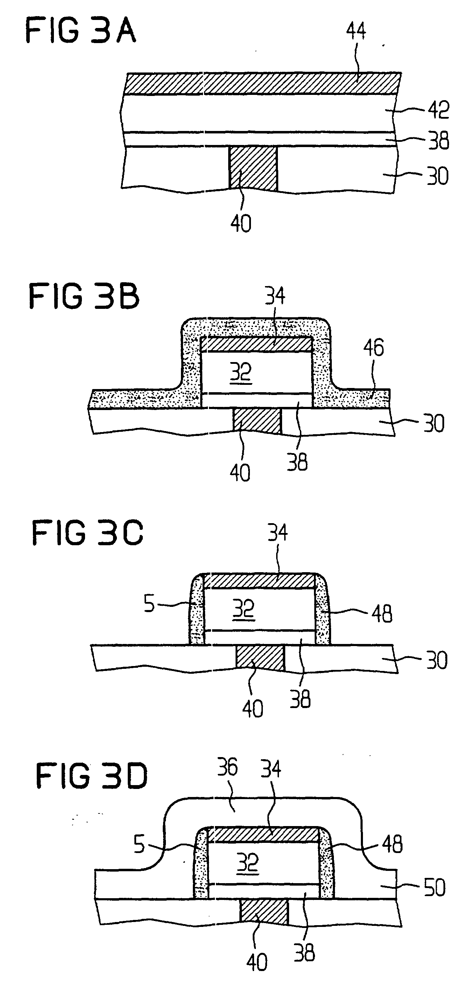

Im weiteren werden einzelne Verfahrensschritte zur Herstellung des Widerstandselements beschrieben. Auf dem Substrat 30 wurde zunächst eine Barrierenschicht 38, gefolgt von einem Elektrodenmaterial 42 und einer metalloxidhaltigen Schicht 44 aufgebracht. Bevorzugt werden diese drei Schichten 38, 42 und 44 gemeinsam unter Verwendung einer Ätzmaske anisotrop geätzt, wobei die untere Elektrode 32 und die Metalloxidschicht 34 entstehen. Auf die so erhaltene Struktur wird ganzflächig eine konforme Polysiliziumschicht 46 abgeschieden und nachfolgend anisotrop geätzt. Im Ergebnis verbleiben seitliche selbstjustierte Randstege 48 an den Seitenflächen der Metalloxidschicht 34, der Barrierenschicht 38 sowie der unteren Elektrode 32. Diese bilden das Widerstandselement 5. Die erhaltene Struktur ist in Figur 3c dargestellt. Abschließend wird ein weiteres Elektrodenmaterial 50 ganzflächig abgeschieden, aus dem die zweite Elektrode 36 gebildet wird. Die Dicke und die Leitfähigkeit: des Widerstandselements 5 ist so eingestellt, daß der Gesamtwiderstand des Widerstandselements 5 einen Wert zwischen 10 und 100 MΩ aufweist.

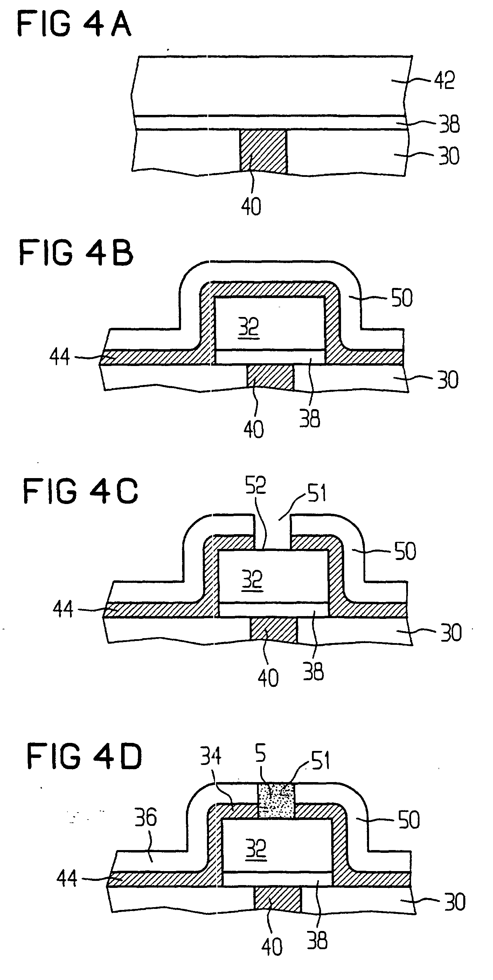

Die Schritte zur Bildung des Widerstandselements 5 in Form eines Kontaktlochs ist in den Figuren 4a bis 4d dargestellt. Ausgegangen wird hier von einer Struktur gemäß Figur 4a, bei der auf dem Substrat 30 die Barrierenschicht 38 und das Elektrodenmaterial 42 angeordnet sind. Nachfolgend werden die beiden Schichten 38 und 42 unter Bildung der Barriere 38 und der unteren Elektrode 32 geätzt und auf die so erhaltene Struktur die metalloxidhaltige Schicht 44 sowie das Elektrodenmaterial 50 abgeschieden. In einem weiteren Prozeßschritt wird ein Kontaktloch 51 auf der Oberseite 52 der ersten Elektrode 32 durch die metalloxidhaltige Schicht 44 und das Elektrodenmaterial 50 geätzt und mit einem leitfähigem Material befüllt. Im Ergebnis ist die in Figur 4d dargestellte Struktur entstanden, bei der auf der Oberseite 52 der ersten Elektrode 32 das Widerstandselement 5 in Form eines mit einem leitfähigen Material, beispielsweise Polysilizium, befüllten Kontaktlochs 51 sitzt. Das Elektrodenmaterial 50 und die metalloxidhaltige Schicht 44 stellen bei dieser Ausführungsform die obere Elektrode 36 sowie die Metalloxidschicht 34 dar.

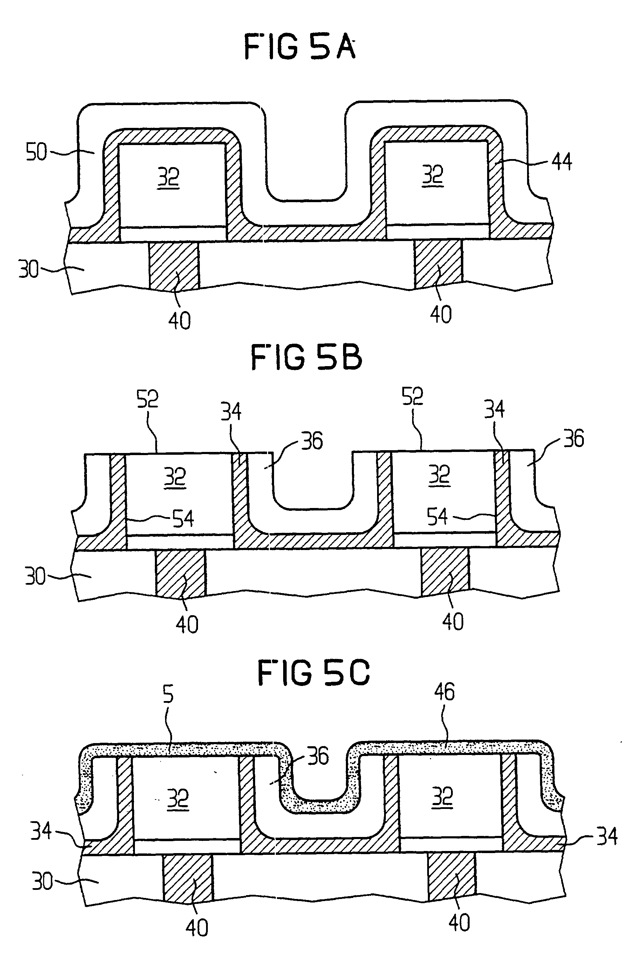

Die Figuren 5a bis 5c stellen die Verfahrensschritte zur Herstellung eines Widerstandselements in Form einer die gesamte Oberseite der ersten Elektrode bedeckenden leitfähigen Schicht dar. In der Figur 5a sind dazu zwei auf der Oberseite des Substrats 30 angeordnete erste Elektroden 32 dargestellt. Diese sind mit der metalloxidhaltigen Schicht 44 und dem Elektrodenmaterial 50 vollständig bedeckt. Durch einen Planarisierungsschritt, beispielsweise durch einen sogenannten CMP-Schritt (Chemical mechanical polishing), werden die metalloxidhaltige Schicht 44 sowie das Elektrodenmaterial 50 von der Oberseite 52 der ersten Elektroden 32 abgetragen. Die an den Seitenwänden 54 der ersten Elektroden 32 verbleibende metalloxidhaltige Schicht 44 und das Elektrodenmaterial 50 stellen die Metalloxidschicht 34 sowie die zweiten Elektroden 36 dar. Die entstandene Struktur ist in Figur 5b dargestellt. Abschließend wird eine Polysiliziumschicht 46 mit vorbestimmter Materialstärke und Leitfähigkeit konform auf die Oberseite 52 der ersten Elektroden 32 abgeschieden. Dabei wird ein elektrischer Kontakt zwischen den ersten Elektroden 32 und den zweiten Elektroden 36 hergestellt, so daß ein Potentialausgleich zwischen beiden Elektroden zur Verhinderung einer elektrostatischen Aufladung ermöglicht wird. Die Polysiliziumschicht 46 stellt in diesem Ausführungsbeispiel das Widerstandselement 5 dar.

Obwohl die ersten Elektroden 32 nun durch die Polysiliziumschicht 46 miteinader verbunden sind, ist ein nachfolgendes Auftrennen der Polysiliziumschicht 46 nicht unbedingt notwendig, kann jedoch optional erfolgen. Da der Widerstandsert der Polysiliziumschicht 46 ausreichend hoch ist, wird durch die Polysiliziumschicht 46 das Einschreiben der remanenten Polarisation in die Metalloxidschicht 46 nicht oder nur unwesentlich durch Veränderungen in Nachbarspeicherzellen beeinflußt.

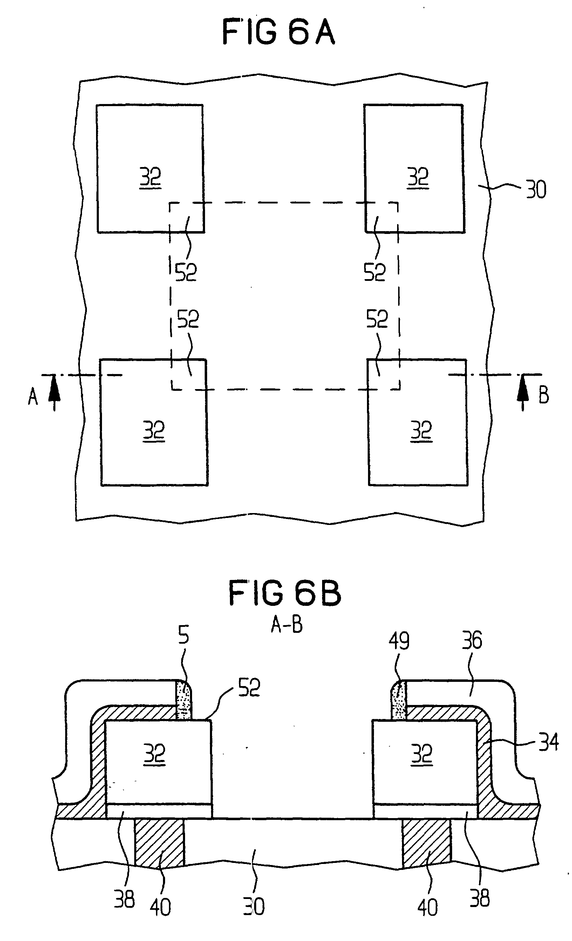

Figur 6a zeigt die Draufsicht auf vier erste Elektroden 32, wobei deren Oberseiten 52 zumindest teilweise durch einen Ätzschritt entblößt wurden d. h., daß dort die Metalloxidschicht 34 und die zweiten Elektroden 36 entfernt wurden. Der entblößte Bereich ist in Figur 6a gestrichelt gekennzeichnet. Der Schnitt entlang der Linie AB ist in Figur 6b dargestellt. Deutlich erkennbar ist, daß auf der Oberseite 52 der ersten Elektroden 32 nur ein Teilbereich von der Metalloxidschicht 34 und der zweiten Elektrode 36 befreit ist und sich dort seitlich der Metalloxidschicht 34 und der zweiten Elektrode 36 ein seitlicher Randsteg 49 befindet. Dieser stellt eine leitende Verbindung zwischen der zweiten Elektrode 36 und der ersten Elektrode 32 her und dient daher als Widerstandselement 5. Das bereichsweise Freilegen der Oberseite 52 der ersten Elektrode 32 erfolgt durch ein maskiertes Ätzen der Metalloxidschicht 34 und der zweiten Elektrode 36, bei dem nur der in Figur 6a gestrichelte Bereich geätzt wird.

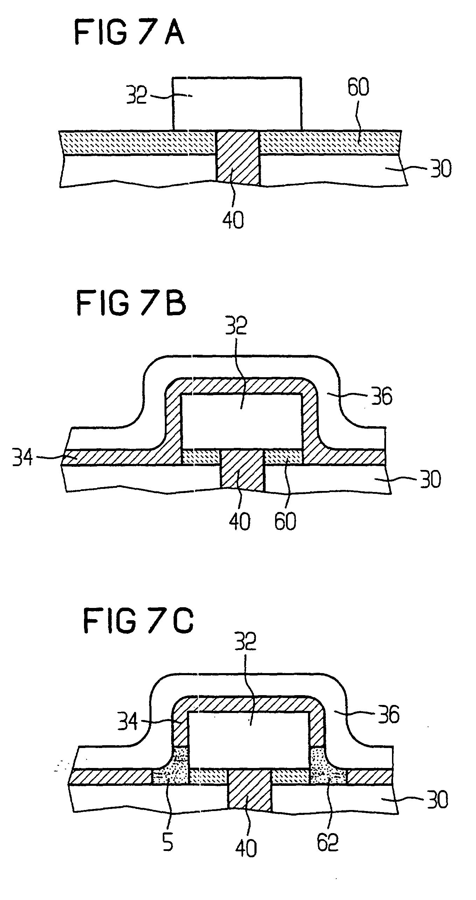

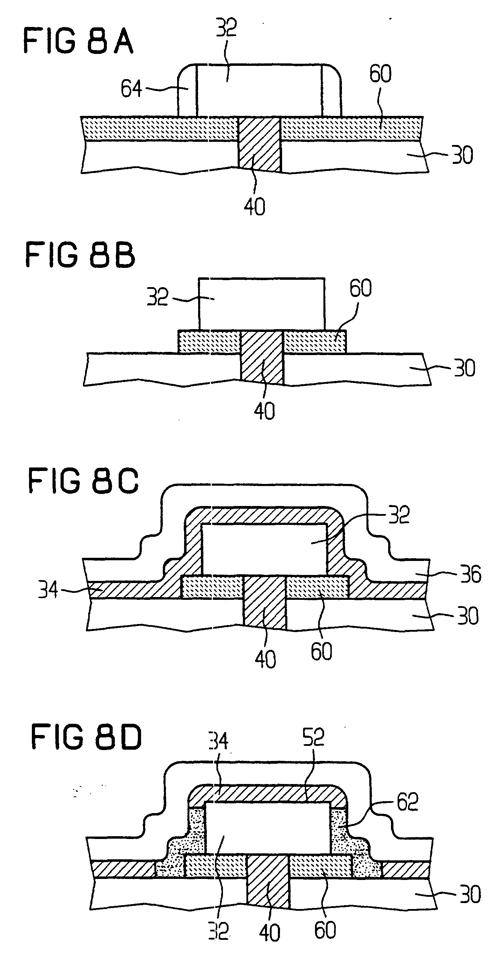

Im folgenden wird die Bildung des Widerstandselements in der Metalloxidschicht in den Figuren 7a bis 7c sowie 8a bis 8d beschrieben. Zunächst wird auf das Substrat 30 eine Diffusionsschicht 60 aufgetragen. Auf dieser sitzt die untere Elektrode 32, die durch Abscheiden eines Elektrodenmaterials und nachfolgender anisotroper Ätzung gebildet wurde. Vor dem Auftragen der unteren Elektrode ist es jedoch vorteilhaft, ein Kontaktloch 40 durch die Diffusionsschicht 40 und das Substrat 30 zu ätzen und mit einem leitfähigem Material zu befüllen, damit die untere Elektrode 32 mit dem Draingebiet 20 des Auswahltransistors 9 verbunden werden kann. Optional kann sich nach der Abscheidung und Ätzung der Diffusionsschicht 60 noch die Bildung der Barrierenschicht 38 anschließen.

Die Diffusionsschicht 60 enthält Diffusionsstoffe, insbesondere Metalle, die bereits in der nachfolgend zu schaffenden Metalloxidschicht 34 enthalten sind. Sofern diese aus SBT besteht, enthält die Diffusionsschicht bevorzugt Bismut. Es sind aber auch andere Metalle, z. B. Ruthenium, Eisen, Tantal und Titan möglich, die sich bevorzugt an den Korngrenzen der sich herausbildenden polykristallinen SBT-Schicht anreichern, und dadurch zu einer lokalen Veränderung der Leitfähigkeit der SBT-Schicht beitragen.

Vor Abscheidung der Metalloxidschicht 34 wird jedoch zunächst die Diffusionsschicht 60 unter Verwendung der unteren Elektrode 32 als Maske geätzt. Auf die so erhaltene Struktur wird wie in Figur 7b gezeigt die Metalloxidschicht 34 und die obere Elektrode 36 aufgetragen. In Abhängigkeit von der Materialstärke der Diffusionsschicht 60 weist diese eine unterschiedlich große Kontaktfläche zur Metalloxidschicht 34 auf. Die Größe der Kontaktfläche bestimmt unter anderem bei der anschließenden Temperaturbehandlung die Größe des zu bildenden Widerstandselements. Bei dieser Temperaturbehandlung werden die Diffusionsstoffe in der Diffusionsschicht 60 aktiviert und diffundieren in die Metalloxidschicht 34 hinein und bilden dort zumindest einen leitfähigen Bereich 62. Die Temperaturbehandlung kann beispielsweise gleichzeitig mit einem notwendigen Ausheilschritt zur Herstellung der ferroelektrischen Eigenschaften der Metalloxidschicht verbunden werden. Da ferroelektrische Kondensatoren bei ihrer Herstellung üblicherweise mehreren Temperaturbehandlungen unterworfen werden, ist nicht notwendigerweise ein zusätzlicher Temperaturschritt zur Bildung der leitfähigen Bereiche 62 in der Metalloxidschicht 34 erforderlich.

Die Ausdehnung der leitfähigen Bereiche 62 sowie deren Leitfähigkeit hängen stark von der Menge der in die Metalloxidschicht diffundierenden Diffusionsstoffe ab. Diese Menge wird unter anderem von der Diffusionsstoffkonzentration in der Diffusionsschicht 60, der Kontaktfläche zwischen Diffusionsschicht 60 und Metalloxidschicht 34 sowie von der gewählten Temperatur und Dauer der einzelnen Temperaturbehandlungen bestimmt. Dadurch sollten diese Parameter geeignet gewählt werden, um den bevorzugt angestrebten Widerstandswert zwischen 10 MΩ und 100 MΩ zu erreichen. Die leitfähigen Bereiche 62, die hier das Widerstandselement 5 darstellen, erstrecken sich bei der hier vorgestellten Ausführungsform einteilig ringförmig im unteren Bereich der unteren Elektrode 32 um diese herum. In Abhängigkeit von der Ausdehnung der leitfähigen Bereiche 62 entlang der unteren Elektrode 32 weisen diese eine effektive Widerstandsfläche auf, durch die die erste Elektrode 32 und die zweite Elektrode 36 zum Erreichen eines Potentialausgleichs miteinander verbunden sind. Bevorzugt ist der leitfähige Bereich 62 in seiner Erstreckung relativ klein gewählt, damit die für die Speicherfunktion notwendige Fläche der ersten Elektrode 32 nicht zu stark eingeschränkt wird. Auch sollte die Metalloxidschicht 34 nur innerhalb des leitfähigen Bereichs in ihrer Leitfähigkeit verändert werden, da durch Veränderung der stöchiometrischen Verhältnisse der Metalloxidschicht 34 bzw. durch den Einbau von Fremdatomen in das Metalloxidgitter die ferroelektrischen Eigenschaften der Metalloxidschicht 34 negativ beeinflußt werden können.

Soll jedoch die Kontaktfläche zwischen der Diffusionsschicht 60 und dem Kondensatordielektrikum bewußt erhöht werden, empfiehlt sich die Verwendung einer Opferschicht 64, die nach Bildung der ersten Elektrode 32 konform abgeschieden und anisotrop geätzt wird, so daß die Opferschicht 64 seitlich der ersten Elektrode 32 in Form von einem oder mehreren Randstegen 64 verbleibt. Diese Randstege 64 dienen zusammen mit der unteren Elektrode 32 als Ätzmaske zum Ätzen der Diffusionsschicht 60. Dadurch ist letztere in ihrer lateralen Ausdehnung größer als die erste Elektrode 32 und steht nach Entfernen der Opferschicht 64 unter dieser um die Breite der Opferschicht 64 hervor. Die Kontaktfläche zwischen der Diffusionsschicht 60 und der Metalloxidschicht 34 ist somit vergrößert und führt dadurch bei der nachfolgenden Temperaturbehandlung zu einem deutlich vergrößerten leitfähigen Bereich 62. Sofern gewünscht, können sich die leitfähigen Bereiche 62 auch bis nahe an die Oberseite 52 der ersten Elektrode 32 erstrecken.

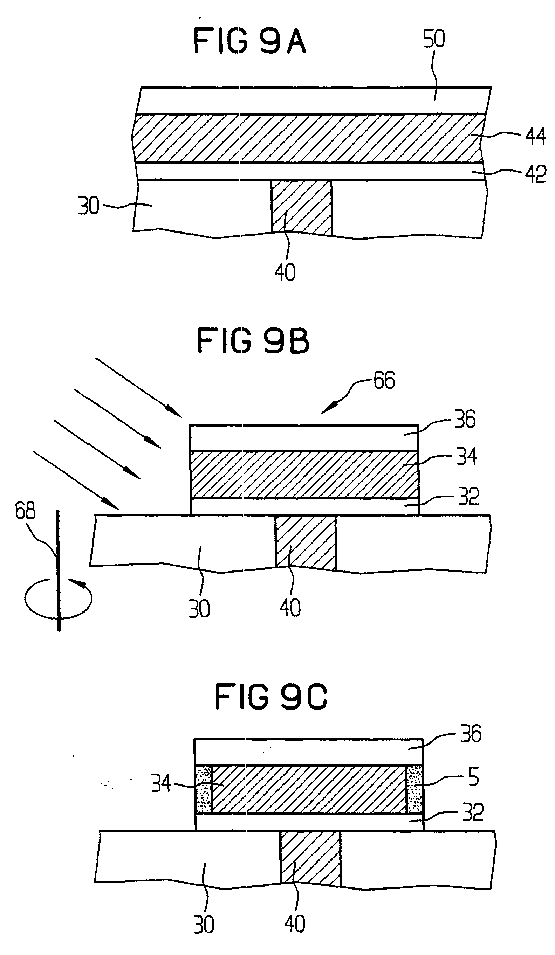

Die Herstellung eines Widerstandselements durch Ionenimplantation soll nachfolgend unter Bezug auf die Figuren 9a bis 9c beschrieben werden. In einem ersten Verfahrensschritt werden ein Elektrodenmaterial 42, eine metalloxidhaltige Schicht 44 sowie ein weiteres Elektrodenmaterial 50 auf ein bereitgestelltes Substrat 30 abgeschieden. Daran schließt sich ein bevorzugter gemeinsamer Äztprozeß an, bei dem ein Schichtstapel 66 aus der dabei gebildeten unteren Elektrode 32, der Metalloxidschicht 34 und der oberen Elektrode 36 entsteht. Die so erhaltene Struktur zeigt Figur 9b.

Ein weiterer Verfahrensschritt dient zur Implantation von Ionen, z.B. von Titan oder Strontium, in die Metalloxidschicht (SBT-Schicht) 34. Dies ist durch die in Figur 9b gezeigten Pfeile angedeutet. Bevorzugt erfolgt die Implantation schräg, so daß die Ionen seitlich in die Metalloxidschicht 34 implantiert werden. Die an die Metalloxidschicht 34 angrenzenden Elektroden 32 und 36 schützen dabei die Metalloxidschicht 34 vor ganzflächiger Implantation. Die Implantation kann einseitig oder an der gesamten Seitenfläche der Metalloxidschicht 34 erfolgen. Bei ersterer Variante beansprucht das zu bildende Widerstandselement 5 nur einen relative geringen Platz. Erfolgt dagegen die Implantation an der gesamten Seitenfläche, ist zwar der Platzbedarf höher, dafür kann jedoch Ionendosis reduziert werden, was zu einer geringen Störung der Metalloxidschicht führt. Bevorzugt wird die Implantation unter Drehung des Schichtstapels 66 um eine senkrecht zu diesem angeordnete Drehachse 68 durchgeführt.

Abschließend erfolgt eine Temperaturbehandlung, bei der die implantierten Ionen aktiviert und das durch die Implantation gestörte Gitter ausgeheilt werden. Im Ergebnis ist ein Widerstandselement 5 im Seitenbereich der Metalloxidschicht 34 entstanden.

## Patentansprüche

1. Halbleiterbauelement mit zumindest einem Kondensator (3), bei dem sich zwischen einer ersten und einer zweiten Elektrode (32, 36) eine Metalloxidschicht (34) befindet, wobei in der Metalloxidschicht (34) durch einen vorgewählten Spannungsunterschied zwischen der ersten und zweiten Elektrode (32, 36) eine remanente elektrische Polarisation herbeiführbar ist,
**dadurch gekennzeichnet**, daß
am Kondensator (3) zumindest ein die erste Elektrode (32) mit der zweiten Elektrode (36) elektrisch verbindendes und in seinem Widerstandswert vorbestimmtes Widerstandselement (5) vorgesehen ist, dessen Widerstandswert geringer als der Widerstandswert der Metalloxidschicht (34) ist.

2. Halbleiterbauelement nach Anspruch 1,
**dadurch gekennzeichnet**, daß
der Widerstandswert des Widerstandselements (5) so bemessen ist, daß ein unbeabsichtigtes Aufladen der ersten und zweiten Elektrode (32, 36) gegeneinander weitestgehend unterbunden ist.

3. Halbleiterbauelement nach Anspruch 1 oder 2,
**dadurch gekennzeichnet**, daß
der Widerstandswert das Widerstandselement (5) etwa zwischen 1 MΩ und 100 GΩ, bevorzugt zwischen 10 MΩ und 100 MΩ liegt.

4. Halbleiterbauelement nach einem der vorhergehenden Ansprüche,
**dadurch gekennzeichnet**, daß
das Widerstandselement (5) aus Polysilizium, aus einem leitfähigen Nitrid oder aus einem Silizid besteht.

5. Halbleiterbauelement nach einem der Ansprüche 1 bis 4,
**dadurch gekennzeichnet**, daß
das Widerstandselement (5) als selbstjustierter seitlicher Randsteg (48) an zumindest einer Seitenfläche der Metalloxidschicht (34) ausgebildet ist.

6. Halbleiterbauelement nach einem der Ansprüche 1 bis 4,
**dadurch gekennzeichnet**, daß
das Widerstandselement (5) durch ein mit leitfähigem Material befülltes Kontaktloch (51) in der Metalloxidschicht (34) gebildet ist.

7. Halbleiterbauelement nach einem der Ansprüche 1 bis 4,
**dadurch gekennzeichnet,** daß
das Widerstandselement (5) durch eine die gesamte Oberseite (52) der ersten Elektrode (32) bedeckende Schicht (46) aus leitfähigem Material gebildet ist, und diese Schicht (46) zumindest an einer Seitenfläche (54) der ersten Elektrode (32) die dort unter Zwischenlage der Metalloxidschicht (34) aufgetragene zweite Elektrode (36) überdeckt.

8. Halbleiterbauelement nach Ansprüche 1 bis 3,
**dadurch gekennzeichnet**, daß
das Widerstandselement (5) durch zumindest einen in seinem Widerstandswert veränderten Bereich (62) der Metalloxidschicht (34) gebildet ist.

9. Halbleiterbauelement nach Anspruch 8,
**dadurch gekennzeichnet**, daß
der in seinem Widerstandswert veränderte Bereich (62) der Metalloxidschicht (34) durch Eindiffusion zumindest eines Diffusionsstoffs gebildet ist.

10. Halbleiterbauelement nach Anspruch 9,
**dadurch gekennzeichnet,** daß
der Diffusionsstoff ein bereits in der Metalloxidschicht (34) enthaltenes Metall ist.

11. Halbleiterbauelement nach Anspruch 9,
**dadurch gekennzeichnet**, daß
der Diffusionsstoff zumindest ein Metall aus der Gruppe Bismut, Strontium, Niob, Blei, Tantal, Titan, Ruthenium, Eisen und Zirkon ist.

12. Halbleiterbauelement nach Anspruch 8,
**dadurch gekennzeichnet**, daß
der in seinem Widerstandswert veränderte Bereich (62) der Metalloxidschicht (34) durch Ionenimplantation geschaffen ist.

13. Halbleiterbauelement nach Anspruch 12,
**dadurch gekennzeichnet**, daß
zumindest ein Metall aus der Gruppe Bismut, Strontium, Niob, Blei, Tantal, Titan, Ruthenium, Eisen und Zirkon in die Metalloxidschicht (34) implantiert ist.

14. Halbleiterbauelement nach einem der vorherigen Ansprüche,
**dadurch gekennzeichnet**, daß
die Metalloxidschicht (34) aus Strontium-Bismut-Tantalat (SBT), niobiumdotiertes Strontium-Bismut-Tantalat (SBTN) oder Blei-Zirkon-Titanat (PZT) besteht.

15. Verfahren zur Herstellung eines Halbleiterbauelements mit zumindest einem Kondensator (3), bei dem sich zwischen einer ersten und einer zweiten Elektrode (32, 36) eine Metalloxidschicht (34) befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist,
mit folgenden Verfahrensschritten:
- Aufbringen eines Elektrodenmaterials (42) und einer metalloxidhaltigen Schicht (44) auf eine Substratoberfläche;
- selektives Ätzen des Elektrodenmaterials (42) und der metalloxidhaltigen Schicht (44) unter Bildung der ersten Elektrode (32) mit darüber angeordneter Metalloxidschicht (34) ;
- konformes Aufbringen eines leitfähigen Materials (46) mit vorbestimmter Materialstärke;
- anisotropes Ätzen des leitfähigen Materials (46), so daß ein Widerstandselement (5) in Form eines selbstjustierten seitlich Randstegs (48) an zumindest einer Seitenflanke der Metalloxidschicht (34) und der ersten Elektrode (32) entsteht; und
- Aufbringen eines Elektrodenmaterials (50) zur Bildung einer zweiten Elektrode (36).

16. Verfahren zur Herstellung eines Halbleiterbauelements mit zumindest einem Kondensator (3), bei dem sich zwischen einer ersten und einer zweiten Elektrode (32, 36) eine Metalloxidschicht (34) befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist,
mit folgenden Verfahrensschritten:
- Aufbringen eines Elektrodenmaterials (42) auf eine Substratoberfläche;
- bereichsweises Ätzen des Elektrodenmaterials (42) unter Bildung der ersten Elektrode (32) ;
- konformes Aufbringen einer metalloxidhaltigen Schicht (44) zur Bildung der Metalloxidschicht (34) ;
- Aufbringen eines Elektrodenmaterials (50) zur Bildung der zweiten Elektrode (36);
- bereichsweises Durchätzen der zweiten Elektrode (36) und der Metalloxidschicht (34) unter Bildung eines bis zur ersten Elektrode reichenden Kontaktlochs (51) ; und
- Füllen dieses Kontaktlochs (51) mit einem leitfähigen Material zur Bildung eines Widerstandselements (5).

17. Verfahren zur Herstellung eines Halbleiterbauelements mit zumindest einem Kondensator (3), bei dem sich zwischen einer ersten und einer zweiten Elektrode (32, 36) eine Metalloxidschicht (34) befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist,
mit folgenden Verfahrensschritten:
- Aufbringen eines Elektrodenmaterials (42) auf eine Substratoberfläche;
- selektives Ätzen des Elektrodenmaterials (42) unter Bildung der ersten Elektrode (32);
- konformes Aufbringen einer metalloxidhaltigen Schicht (44) zur Bildung der Metalloxidschicht (34) ;
- Aufbringen eines Elektrodenmaterials (50) zur Bildung der zweiten Elektrode (36) ;
- zumindest bereichsweises Entfernen der Metalloxidschicht (34) und der zweiten Elektrode (36) von einer Oberseite (52) der ersten Elektrode (32) ; und
- konformes Aufbringen eines leitfähigen Materials (46) mit vorbestimmter Materialstärke, das durch den Kontakt mit der Oberseite (52) der ersten Elektrode (32) und der zweiten Elektrode (36) das Widerstandselement (5) bildet.

18. Verfahren nach Anspruch 17,
**dadurch gekennzeichnet**, daß
die Metalloxidschicht (34) und die zweite Elektrode (36) vollständig von der Oberseite (52) der ersten Elektrode (32) entfernt werden, so daß das leitfähige Material (46) vollständig die Oberseite (52) und zumindest einige Seitenbereiche (54) der ersten Elektrode (32) bedeckt, wobei an den Seitenbereichen (54) zwischen dem leitfähigen Material (46) und der ersten Elektrode (32) die Metalloxidschicht (34) und die zweite Elektrode (36) verbleiben.

19. Verfahren nach Anspruch 17,
**dadurch gekennzeichnet**, daß
durch nachfolgendes anisotropes Ätzen des leitfähigen Material (46) ein selbstjustierter seitlicher Randsteg (49) auf der Oberseite (52) der ersten Elektrode (32) und seitlich der bereichsweise entfernten Metalloxidschicht (34) und der zweiten Elektrode (36) verbleibt, der das Widerstandselement (5) bildet.

20. Verfahren zur Herstellung eines Halbleiterbauelements mit zumindest einem Kondensator (3), bei dem sich zwischen einer ersten und einer zweiten Elektrode (32, 36) eine Metalloxidschicht (34) befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist,
mit folgenden Verfahrensschritten:
- Aufbringen einer zumindest einen Diffusionsstoff enthaltenden Diffusionsschicht (60) auf eine Substratoberfläche;
- Aufbringen eines Elektrodenmaterials (40) auf diese Schicht (60) ;
- bereichsweises Ätzen des Elektrodenmaterials (40) unter Bildung der ersten Elektrode (32) und bereichsweises Ätzen der Diffusionsschicht (60) ;
- konformes Aufbringen einer metalloxidhaltigen Schicht (44) zur Bildung der Metalloxidschicht (34) ;
- Aufbringen eines Elektrodenmaterials (50) zur Bildung der zweiten Elektrode (36); und
- Durchführen einer Temperaturbehandlung, bei der der Diffusionsstoff aus der Diffusionsschicht (60) zumindest teilweise in die Metalloxidschicht (34) unter Bildung des Widerstandselements (5) diffundiert.

21. Verfahren nach Anspruch 20,
**dadurch gekennzeichnet**, daß
nach dem Aufbringen der Diffusionsschicht (60) durch diese hindurch ein Kontaktloch (40) geätzt und nachfolgend mit einem leitfähigen Material aufgefüllt wird.

22. Verfahren nach Anspruch 21 oder 20,
**dadurch gekennzeichnet**, daß
nach dem Ätzen des Elektrodenmaterials (40) zur Bildung der ersten Elektrode (32) eine konforme Opferschicht (64) abgeschieden und diese nachfolgend anisotrop unter Bildung eines unmittelbar seitlich neben der ersten Elektrode angeordneten Randstegs (64) geätzt wird, so daß dieser Randsteg (64) zusammen mit der ersten Elektrode (32) beim nachfolgenden Ätzen der Diffusionsschicht (60) als Ätzmaske dient und die geätzte Diffusionsschicht (60) somit um die Breite des Randstegs (60) unter der ersten Elektrode (32) hervorsteht.

23. Verfahren zur Herstellung eines Halbleiterbauelements mit zumindest einem Kondensator (3), bei dem sich zwischen einer ersten und einer zweiten Elektrode (32, 36) eine Metalloxidschicht (34) befindet, wobei in der Metalloxidschicht durch einen vorgewählten Spannungsunterschied zwischen der ersten und zweiten Elektrode eine remanente elektrische Polarisation herbeiführbar ist, und an dem zumindest ein die erste Elektrode mit der zweiten Elektrode elektrisch verbindendes und in seinem Widerstandswert vorbestimmtes Widerstandselement vorgesehen ist, dessen Widerstandswert geringer als der Widerstandswert der Metalloxidschicht ist,
mit folgenden Verfahrensschritten:
- Aufbringen eines Elektrodenmaterials (42) auf eine Substratoberfläche;
- Aufbringen einer metalloxidhaltigen Schicht (44) auf das Elektrodenmaterial (42);
- Aufbringen eines weiteren Elektrodenmaterials (50) auf die metalloxidhaltige Schicht (44);
- zumindest bereichsweises Entfernen der beiden Elektrodenmaterialien (42, 50) und der metalloxidhaltigen Schicht (44) unter Bildung eines Schichtstapels (66) bestehend aus der unteren Elektrode (32), der Metalloxidschicht (34) und der zweiten Elektrode (36); und
- Implantieren von Ionen zumindest in die Metalloxidschicht (34).

24. Verfahren nach Anspruch 23,
**dadurch gekennzeichnet**, daß
die Implantation der Ionen seitlich in die Metalloxidschicht (34) erfolgt.

25. Verfahren nach Anspruch 24,
**dadurch gekennzeichnet**, daß
der Schichtstapel (66) zur gleichmäßigen Ionenimplantation während der Implantation um eine im wesentlichen senkrecht zum Schichtstapel angeordnete Achse (68) gedreht wird.

26. Verfahren nach einem der Ansprüche 23 bis 25,
**dadurch gekennzeichnet**, daß
nach der Implantation der Ionen ein Temperaturschritt durchgeführt wird.

27. Verfahren nach einem der Ansprüche 23 bis 26,
**dadurch gekennzeichnet**, daß
zumindest ein Metall aus der Gruppe Bismut, Strontium, Niob, Blei, Tantal, Titan, Ruthenium, Eisen und Zirkon in die Metalloxidschicht (34) implantiert wird.

## Claims

1. Semiconductor component having at least one capacitor (3), in which a metal oxide layer (34) is situated between a first and a second electrode (32, 36), it being possible to bring about a remanent electrical polarization in the metal oxide layer (34) by means of a preselected voltage difference between the first and second electrodes (32, 36),
**characterized in that**
at least one resistance element (5) is provided at the capacitor (3), which resistance element electrically connects the first electrode (32) to the second electrode (36) and has a predetermined resistance, the resistance of which resistance element is lower than the resistance of the metal oxide layer (34).

2. Semiconductor component according to Claim 1,
**characterized in that**
the resistance of the resistance element (5) is dimensioned such that unintentional charging of the first and second electrodes (32, 36) relative to one another is prevented to the greatest possible extent.

3. Semiconductor component according to Claim 1 or 2,
**characterized in that**
the resistance of the resistance element (5) lies approximately between 1 MΩ and 100 GΩ, preferably between 10 MΩ and 100 MΩ.

4. Semiconductor component according to one of the preceding claims,
**characterized in that**
the resistance element (5) is composed of polysilicon, a conductive nitride or a silicide.

5. Semiconductor component according to one of Claims 1 to 4,
**characterized in that**
the resistance element (5) is designed as a self-aligned lateral edge web (48) on at least one side area of the metal oxide layer (34).

6. Semiconductor component according to one of Claims 1 to 4,
**characterized in that**
the resistance element (5) is formed by a contact hole (51) filled with conductive material in the metal oxide layer (34).

7. Semiconductor component according to one of Claims 1 to 4,
**characterized in that**
the resistance element (5) is formed by a layer (46) made of conductive material which covers the entire top side (52) of the first electrode (32), and this layer (46), at least on a side area (54) of the first electrode (32), covers the second electrode (36) applied there with the interposition of the metal oxide layer (34).

8. Semiconductor component according to Claims 1 to 3,
**characterized in that**
the resistance element (5) is formed by at least one region (62) of the metal oxide layer (34), said region having an altered resistance.

9. Semiconductor component according to Claim 8,
**characterized in that**
that region (62) of the metal oxide layer (34) which has an altered resistance is formed by indiffusion of at least one diffusion substance.

10. Semiconductor component according to Claim 9,
**characterized in that**
the diffusion substance is a metal already contained in the metal oxide layer (34).

11. Semiconductor component according to Claim 9,
**characterized in that**
the diffusion substance is at least one metal from the group bismuth, strontium, niobium, lead, tantalum, titanium, ruthenium, iron and zirconium.

12. Semiconductor component according to Claim 8,
**characterized in that**
that region (62) of the metal oxide layer (34) which has an altered resistance is produced by ion implantation.

13. Semiconductor component according to Claim 12,
**characterized in that**
at least one metal from the group bismuth, strontium, niobium, lead, tantalum, titanium, ruthenium, iron and zirconium is implanted into the metal oxide layer (34).

14. Semiconductor component according to one of the preceding claims,
**characterized in that**
the metal oxide layer (34) is composed of strontium bismuth tantalate (SBT), niobium-doped. strontium bismuth tantalate (SBTN) or lead zirconium titanate (PZT).

15. Method for fabricating a semiconductor component having at least one capacitor (3), in which a metal oxide layer (34) is situated between a first and a second electrode (32, 36), it being possible to bring about a remanent electrical polarization in the metal oxide layer by means of a preselected voltage difference between the first and second electrodes and at least one resistance element being provided at said capacitor, which resistance element electrically connects the first electrode to the second electrode and has a predetermined resistance, the resistance of which resistance element is lower than the resistance of the metal oxide layer,
having the following method steps:
- application of an electrode material (42) and of a metal oxide-containing layer (44) to a substrate surface;
- selective etching of the electrode material (42) and of the metal oxide-containing layer (44) with the formation of the first electrode (32) with metal oxide layer (34) arranged above it;
- conformal application of a conductive material (46) having a predetermined material thickness;
- anisotropic etching of the conductive material (46) to produce a resistance element (5) in the form of a self-aligned lateral edge web (48) on at least one sidewall of the metal oxide layer (34) and of the first electrode (32); and
- application of an electrode material (50) for the purpose of forming a second electrode (36).

16. Method for fabricating a semiconductor component having at least one capacitor (3), in which a metal oxide layer (34) is situated between a first and a second electrode (32, 36), it being possible to bring about a remanent electrical polarization in the metal oxide layer by means of a preselected voltage difference between the first and second electrodes and at least one resistance element being provided at said capacitor, which resistance element electrically connects the first electrode to the second electrode and has a predetermined resistance, the resistance of which resistance element is lower than the resistance of the metal oxide layer,
having the following method steps:
- application of an electrode material (42) to a substrate surface;
- etching of the electrode material (42) in regions with the formation of the first electrode (32);
- conformal application of a metal oxide-containing layer (44) for the purpose of forming the metal oxide layer (34);
- application of an electrode material (50) for the purpose of forming the second electrode (36);
- etching through of the second electrode (36) and of the metal oxide layer (34) in regions with the formation of a contact hole (51) reaching down to the first electrode; and
- filling of this contact hole (51) with a conductive material for the purpose of forming a resistance element (5).

17. Method for fabricating a semiconductor component having at least one capacitor (3), in which a metal oxide layer (34) is situated between a first and a second electrode (32, 36), it being possible to bring about a remanent electrical polarization in the metal oxide layer by means of a preselected voltage difference between the first and second electrodes and at least one resistance element being provided at said capacitor, which resistance element electrically connects the first electrode to the second electrode and has a predetermined resistance, the resistance of which resistance element is lower than the resistance of the metal oxide layer,
having the following method steps:
- application of an electrode material (42) to a substrate surface;
- selective etching of the electrode material (42) with the formation of the first electrode (32);
- conformal application of a metal oxide-containing layer (44) for the purpose of forming the metal oxide layer (34);
- application of an electrode material (50) for the purpose of forming the second electrode (36);
- removal of the metal oxide layer (34) and of the second electrode (36) at least in regions from a top side (52) of the first electrode (32); and
- conformal application of a conductive material (46) having a predetermined material thickness, which forms the resistance element (5) as a result of the contact with the top side (52) of the first electrode (32) and the second electrode (36).

18. Method according to Claim 17,
**characterized in that**
the metal oxide layer (34) and the second electrode (36) are removed completely from the top side (52) of the first electrode (32), with the result that the conductive material (46) completely covers the top side (52) and at least some side regions (54) of the first electrode (32), the metal oxide layer (34) and the second electrode (36) remaining at the side regions (54) between the conductive material (46) and the first electrode (32).

19. Method according to Claim 17,
**characterized in that**
by means of subsequent anisotropic etching of the conductive material (46), a self-aligned lateral edge web (49) remains on the top side (52) of the first electrode (32) and on the side of the metal oxide layer (34), which has been removed in regions, and of the second electrode (36), said web forming the resistance element (5).

20. Method for fabricating a semiconductor component having at least one capacitor (3), in which a metal oxide layer (34) is situated between a first and a second electrode (32, 36), it being possible to bring about a remanent electrical polarization in the metal oxide layer by means of a preselected voltage difference between the first and second electrodes and at least one resistance element being provided at said capacitor, which resistance element electrically connects the first electrode to the second electrode and has a predetermined resistance, the resistance of which resistance element is lower than the resistance of the metal oxide layer,
having the following method steps:
- application of a diffusion layer (60) containing at least one diffusion substance to a substrate surface;
- application of an electrode material (40) to this layer (60);
- etching of the electrode material (40) in regions with the formation of the first electrode (32) and etching of the diffusion layer (60) in regions;
- conformal application of a metal oxide-containing layer (44) for the purpose of forming the metal oxide layer (34);
- application of an electrode material (50) for the purpose of forming the second electrode (36); and
- performance of a heat treatment in the course of which the diffusion substance diffuses from the diffusion layer (60) at least partly into the metal oxide layer (34) with the formation of the resistance element (5).

21. Method according to Claim 20,
**characterized in that**
after the application of the diffusion layer (60), a contact hole (40) is etched through the latter and subsequently filled with a conductive material.

22. Method according to Claim 21 or 20,
**characterized in that**
after the etching of the electrode material (40) for the purpose of forming the first electrode (32), a conformal sacrificial layer (64) is deposited and is subsequently etched anisotropically with the formation of an edge web (64) arranged directly laterally next to the first electrode, with the result that this edge web (64), together with the first electrode (32), serves as an etching mask during the subsequent etching of the diffusion layer (60) and the etched diffusion layer (60) consequently protrudes by the width of the edge web (60) under the first electrode (32).

23. Method for fabricating a semiconductor component having at least one capacitor (3), in which a metal oxide layer (34) is situated between a first and a second electrode (32, 36), it being possible to bring about a remanent electrical polarization in the metal oxide layer by means of a preselected voltage difference between the first and second electrodes and at least one resistance element being provided at said capacitor, which resistance element electrically connects the first electrode to the second electrode and has a predetermined resistance, the resistance of which resistance element is lower than the resistance of the metal oxide layer,
having the following method steps:
- application of an electrode material (42) to a substrate surface;
- application of a metal oxide-containing layer (44) to the electrode material (42);
- application of a further electrode material (50) to the metal oxide-containing layer (44);
- removal of the two electrode materials (42, 50) and of the metal oxide-containing layer (44) at least in regions with the formation of a layer stack (66) comprising the lower electrode (32), the metal oxide layer (34) and the second electrode (36); and
- implantation of ions at least into the metal oxide layer (34).

24. Method according to Claim 23,
**characterized in that**
the ions are implanted laterally into the metal oxide layer (34).

25. Method according to Claim 24,
**characterized in that**
the layer stack (66) is rotated about an axis (68), which is arranged essentially perpendicularly to the layer stack, during the implantation for the purpose of uniform ion implantation.

26. Method according to one of Claims 23 to 25,
**characterized in that**
after the implantation of the ions, a heat-treatment step is carried out.

27. Method according to one of Claims 23 to 26,
**characterized in that**
at least one metal from the group bismuth, strontium, niobium, lead, tantalum, titanium, ruthenium, iron and zirconium is implanted into the metal oxide layer (34)

## Revendications

1. Composant à semi-conducteur comprenant au moins un condensateur (3), dans lequel il y a, entre une première et une seconde électrode (32, 36), une couche (34) en oxyde métallique, une polarisation électrique rémanente pouvant être provoquée dans la couche (34) en oxyde métallique par une différence de tension sélectionnée à l'avance entre la première et la seconde électrode (32, 36)
**caractérisé en ce que**
il est prévu sur le condensateur (3) au moins un élément (5) résistant reliant électriquement la première électrode (32) à la seconde électrode (36) et dont la valeur de la résistance est déterminée à l'avance, sa valeur de résistance étant plus petite que la valeur de la résistance de la couche (34) d'oxyde métallique.

2. Composant à semi-conducteur suivant la revendication 1,
**caractérisé en ce que**
la valeur de la résistance de l'élément (5) résistant est telle que toute charge non délibérée de la première et de la seconde électrode (32, 36) l'une par rapport à l'autre est supprimée dans une grande mesure.

3. Composant à semi-conducteur suivant la revendication 1 ou 2,
**caractérisé en ce que**
la valeur de la résistance de l'élément (5) résistant est comprise entre environ 1 MΩ et 100 GΩ, de préférence entre 10 MΩ et 100 MΩ.

4. Composant à semi-conducteur suivant l'une des revendications précédentes,
**caractérisé en ce que**
l'élément (5) résistant est en polysilicium, en un nitrure conducteur ou en un siliciure.

5. Composant à semi-conducteur suivant l'une des revendications 1 à 4,
**caractérisé en ce que**
l'élément (5) résistant est constitué sous la forme d'une nervure (48) marginale latérale auto-alignée sur au moins une face latérale de la couche (34) d'oxyde métallique.

6. Composant à semi-conducteur suivant l'une des revendications 1 à 4,
**caractérisé en ce que**
l'élément (5) résistant est formé par un trou (51) de contact empli de matériau conducteur et ménagé dans la couche (34) d'oxyde métallique.

7. Composant à semi-conducteur suivant l'une des revendications 1 à 4,
**caractérisé en ce que**
l'élément (5) résistant est formé par une couche (46) en matériau conducteur recouvrant toute la face (52) supéirieure de la première électrode (32) et cette couche (46) recouvre au moins sur une face (54) latérale de la première électrode (32) la seconde électrode (36) qui y est déposée avec interposition de la couche (34) d'oxyde métallique.

8. Composant à semi-conducteur suivant l'une des revendications 1 à 3,
**caractérisé en ce que**
l'élément (5) résistant est formé par au moins une zone (62) de la couche (34) d'oxyde métallique, dont la valeur de la résistance est modifiée.

9. Composant à semi-conducteur suivant la revendication 8,
**caractérisé en ce que**
la zone (62) de la couche (34) d'oxyde métallique, dont la valeur de la résistance est modifiée, est formée par diffusion d'au moins une substance de diffusion.

10. Composant à semi-conducteur suivant la revendication 9,
**caractérisé en ce que**
la substance de diffusion est un métal déjà contenu dans la couche (34) d'oxyde métallique.

11. Composant à semi-conducteur suivant la revendication 9,
**caractérisé en ce que**
la substance de diffusion est au moins un métal du groupe du bismuth, du strontium, du niobium, du plomb, du tantale, du titane, du ruthénium, du fer et du zirconium.

12. Composant à semi-conducteur suivant la revendication 8,
**caractérisé en ce que**
la zone (62) de la couche (34) d'oxyde métallique, dont la valeur de la résistance est modifiée, est produite par implantation d'ions.

13. Composant à semi-conducteur suivant la revendication 12,
**caractérisé en ce que**
au moins un métal du groupe du bismuth, du strontium, du niobium, du plomb, du tantale, du titane, du ruthénium, du fer et du zirconium est implanté dans la couche (34) d'oxyde métallique.

14. Composant à semi-conducteur selon l'une des revendications précédentes,
**caractérisé en ce que**
la couche (34) d'oxyde métallique est en tantalate de strontium et de bismuth (SBT), en tantalate de strontium et de bismuth dopé au niobium (SBTN) ou en titanate de plomb et de zirconium (PZT).

15. Procédé de fabrication d'un composant à semi-conducteur ayant au moins un condensateur dans lequel il se trouve, entre une première et une seconde électrode (32, 36), une couche (34) d'oxyde métallique, une polarisation électrique rémanente pouvant être provoquée dans la couche d'oxyde métallique par une difference de tension sélectionnée à l'avance entre la première et la seconde électrode, et il est prévu un élément résistant reliant électriquement la première électrode à la seconde électrode et dont la valeur de la résistance est déterminée à l'avance, sa valeur de résistance étant plus petite que la valeur de la résistance de la couche d'oxyde métallique, ayant les stades suivants de procédé :
- dépôt d'un matériau (42) d'électrode et d'une couche (44) contenant un oxyde métallique sur une surface de substrat ;
- attaque chimique sélective du matériau (42) d'électrode et la couche (44) contenant un oxyde métallique avec formation de la première électrode (32) ayant au-dessus la couche (34) d'oxyde métallique ;
- dépôt conforme d'un matériau (46) conducteur en une épaisseur déterminée à l'avance ;
- attaque chimique anisotrope du matériau (46) conducteur de manière à créer un élément (5) résistant sous la forme d'une nervure (48) marginale latérale s'auto-alignant sur au moins l'un des flancs latéraux de la couche (34) d'oxyde métallique et de la première électrode (32) ; et
- dépôt d'un matériau (50) d'électrode pour former une seconde électrode (36).

16. Procédé de fabrication d'un composant à semi-conducteur ayant au moins un condensateur dans lequel il se trouve, entre une première et une seconde électrode (32, 36), une couche (34) d'oxyde métallique, une polarisation électrique rémanente pouvant être provoquée dans la couche d'oxyde métallique par une différence de tension sélectionnée à l'avance entre la première et la seconde électrode, et il est prévu un élément résistant reliant électriquement la première électrode à la seconde électrode et dont la valeur de la résistance est déterminée à l'avance, sa valeur de résistance étant plus petite que la valeur de la résistance de la couche d'oxyde métallique, ayant les stades suivants de procédé :
- dépôt d'un matériau (42) d'électrode sur une surface de substrat ;
- attaque chimique sélective par zone du matériau (42) d'électrode avec formation de la première électrode (32) ;
- dépôt conforme d'une couche (44) contenant un oxyde métallique pour la formation de la couche (34) d'oxyde métallique ;
- dépôt d'un matériau (50) d'électrode pour la formation de la seconde électrode (36) ;
- attaque chimique par zone de la seconde électrode (36) et de la couche (34) d'oxyde métallique avec formation d'un trou (51) de contact allant jusqu'à la première électrode ; et
- emplissage de ce trou (51) de contact d'un matériau conducteur pour la formation d'un élément (5) résistant.

17. Procédé de fabrication d'un composant à semi-conducteur ayant au moins un condensateur dans lequel il se trouve, entre une première et une seconde électrode (32, 36), une couche (34) d'oxyde métallique, une polarisation électrique rémanente pouvant être provoquée dans la couche d'oxyde métallique par une différence de tension sélectionnée à l'avance entre la première et la seconde électrode, et il est prévu un élément résistant reliant électriquement la première électrode à la seconde électrode et dont la valeur de la résistance est déteriminée à l'avance, sa valeur de résistance étant plus petite que la valeur de la résistance de la couche d'oxyde métallique, comportant les stades suivants de procédé :
- dépôt d'un matériau (42) d'électrode sur une surface de substrat ;
- attaque chimique sélective du matériau (42) d'électrode avec formation de la première électrode (32) ;
- dépôt conforme d'une couche (44) contenant un oxyde métallique pour la formation de la couche (34) d'oxyde métallique ;
- dépôt d'un matériau (50) d'électrode pour la formation de la seconde électrode (36) ;
- élimination au moins par zone de la couche (34) d'oxyde métallique et de la seconde électrode (36) par une face (52) supérieure de la première électrode (32) ; et
- dépôt conforme d'un matériau (46) conducteur en une épaisseur déterminée à l'avance, qui forme par le contact avec la face (52) supérieure de la première électrode (32) et de la seconde électrode (36) l'élément (5) résistant.

18. Procédé suivant la revendication 17,
**caractérisé en ce que**
il consiste à éliminer la couche (34) d'oxyde métallique et la seconde électrode (36) complètement de la face (52) supérieure de la première électrode (32) de façon à recouvrir du matériau (46) conducteur entièrement la face (52) supérieure et au moins quelques zones (54) latérales de la première électrode (32), la couche (34) d'oxyde métallique et la seconde électrode (36) subsistant sur les zones (54) latérales comprises entre le matériau (46) conducteur et la première électrode (32).

19. Procédé suivant la revendication 17,
**caractérisé en ce que**
après l'attaque chimique anisotrope venant ensuite du matériau (46) conducteur il subsiste une nervure (49) marginale latérale auto-alignée, sur la face (52) supérieure de la première électrode (32) et latéralement à la couche (34) d'oxyde métallique éliminée par zone et à la seconde électrode (36), qui forme l'élément (5) résistant.

20. Procédé de fabrication d'un composant à semi-conducteur ayant au moins un condensateur dans lequel il se trouve, entre une première et une seconde électrode (32, 36), une couche (34) d'oxyde métallique, une polarisation électrique rémanente pouvant être provoquée dans la couche d'oxyde métallique par une différence de tension sélectionnée à l'avance entre la première et la seconde électrode, et il est prévu un élément résistant reliant électriquement la première électrode à la seconde électrode et dont la valeur de la résistance est déterminée à l'avance, sa valeur de résistance étant plus petite que la valeur de la résistance de la couche d'oxyde métallique, ayant les stades suivants de procédé :
- dépôt d'au moins une couche (60) de diffusion contenant une substance de diffusion sur une surface de substrat;
- dépôt d'un matériau (40) d'électrode sur cette couche (60) ;
- attaque chimique par zone du matériau (40) d'électrode avec formation de la première électrode (32) et attaque chimique par zone de la couche (60) de diffusion ;
- dépôt conforme d'une couche (44) contenant un oxyde métallique pour la formation de la couche (34) d'oxyde métallique ;
- dépôt d'un matériau (50) d'électrode pour la formation de l'électrode (36) ;
- traitement thermique dans lequel la substance de diffusion diffuse de la couche (60) de diffusion au moins partiellement dans la couche (34) d'oxyde métallique avec formation de l'élément (5) résistant.

21. Procédé suivant la revendication 20,
**caractérisé en ce que**
après le dépôt de la couche (60) de diffusion il est ménagé par attaque chimique au travers de celle-ci un trou (40) de contact qui est ensuite empli d'un matériau conducteur.

22. Procédé suivant la revendication 21 ou 20,
**caractérisé en ce que**
après l'attaque chimique du matériau (40) d'électrode il est déposé pour la formation de la première électrode une couche (64) sacrificielle conforme et celle-ci est ensuite attaquée chimiquement de manière anisotrope avec formation d'une nervure (64) marginale disposée directement latéralement à côté de la première électrode de sorte que cette nervure (64) marginale sert en même temps que la première électrode (32), lors de l'attaque chimique venant ensuite de la couche (60) de diffusion, de masque d'attaque chimique et la couche (60) de diffusion attaquée chimiquement fait ainsi saillie de la largeur de la nervure (60) marginale en dessous de la première électrode (32).

23. Procédé de fabrication d'un composant à semi-conducteur ayant au moins un condensateur dans lequel il se trouve, entre une première et une seconde électrode (32, 36), une couche (34) d'oxyde métallique, une polarisation électrique rémanentes pouvant être provoquée dans la couche d'oxyde métallique par une différence de tension sélectionnée à l'avance entre la première et la seconde électrode, et il est prévu un élément résistant reliant électriquement la première électrode à la seconde électrode et dont la valeur de la résistance est déterminée à l'avance, sa valeur de résistance étant plus petite que la valeur de la résistance de la couche d'oxyde métallique, ayant les stades suivants de procédé :
- dépôt d'un matériau (42) d'électrode sur une surface de substrat ;
- dépôt d'une couche (44) contenant un oxyde métallique sur le matériau (42) d'électrode ;
- dépôt d'un autre matériau (50) d'électrode sur la couche (44) d'oxyde métallique ;
- élimination au moins par zone des deux matériaux (42) et (50) d'électrode et de la couche (44) contenant de l'oxyde métallique avec formation d'une pile de couches (66) constituée de l'électrode (32) inférieure de la couche (34) d'oxyde métallique et de la seconde électrode (36) ; et
- implantation d'ions au moins dans la couche (34) d'oxyde métallique.

24. Procédé suivant la revendication 23,
**caractérisé en ce que**
il consiste à effectuer l'implantation des ions latéralement dans la couche (34) d'oxyde métallique.

25. Procédé suivant la revendication 24,
**caractérisé en ce que**
la pile de couches (66) est, pour obtenir une implantation d'ions uniformes, mise, pendant l'implantation, en rotation autour d'un axe (68) sensiblement perpendiculaire à la pile de couches.

26. Procédé suivant l'une des revendications 23 à 25,
**caractérisé en ce que**
il consiste à effectuer après l'implantation des ions un stade de mise en température.

27. Procédé suivant l'une des revendications 23 à 26,
**caractérisé en ce que**
il consiste à implanter au moins un métal du groupe du bismuth, du strontium, du niobium, du plomb, du tantale, du titane, du ruthénium, du fer et du zirconium dans la couche (34) d'oxyde métallique.
